# EUROPEAN PATENT APPLICATION

(11) **EP 0 745 658 A1**
(43) Date of publication of application: **04.12.1996**
(21) Application number: 95201681.4
(22) Date of filing: 21.06.1995
(51) Int. Cl.: C09K 11/06, H01S 3/213, H01L 33/00, C08G 61/02

(54) **Light-emitting copolymers**

(30) Priority: 30.05.1995 EP 95201402
(71) Applicant: STICHTING SCHEIKUNDIG ONDERZOEK IN NEDERLAND (SON), NL-2509 AC Den Haag (NL); Stichting voor de Technische Wetenschappen, NL-3502 GA Utrecht (NL); Rijksuniversiteit te Groningen, NL-9712 CP Groningen (NL)
(72) Inventor: Wildeman, Jurjen, NL-9731 MS Groningen (NL); Hilberer, Alain, NL-9743 PA Groningen (NL); Brouwer, Hendrik-Jan, NL-4707 DV Roosendaal (NL); Krasnikov, Victor Valirivich, NL-9743 PC Groningen (NL); Hadziioannou, Georges, NL-9321 EL Peize (NL)
(74) Representative: Kupecz, Arpad

(57) **Abstract**

The present invention provides the possibility to control the emission wavelength of a light emitting polymer. The invention thus provides a copolymer consisting of light emitting units and interruption units. The interruption units interrupt the coplanar orientation of the molecule and thereby the conjugation length thus influencing the wavelength of the emitted light.

## Description

The present invention relates to new copolymers, having light-emitting properties and to the use of the copolymers in various applications.

In the last twenty years there was a dramatically growing interest in the development of organic material for use in opto-electronic devices (for recent reviews see 1, 2). When compared to classical inorganic semi-conductors, organic material and especially polymers, present a lot of potential advantages, such as very good mechanical and optical properties, ease of processability and almost unlimited number of accessible chemical structures.

The high photoluminescence observed in many organic semi-conductors raised the possibility of solid-state light emission under applied electric field (electroluminescence). Light-emitting devices (LEDs) were first fabricated from small organic molecules (3, 4). These systems present the main disadvantage that active molecules can recrystallize during device operation, leading to poor device stability. The use of conjugated polymers, potentially more stable, in such devices was first realized in the early 1990's (5, 6). Since then a great number of polymer materials suitable for LEDs was developed (7, 8).

Furthermore, it was realized that the high photoluminescence quantum yield of conjugated polymers made them promising candidates for active laser media in liquid or solid state. Furthermore, due to their good processability and mechanical properties, polymeric dyes have a potential advantage as active gain media in dye doped polymeric optical devices. Laser action of a semiconducting polymer (MEH-PPV) in the liquid state (38, 39) operating in the yellow/red wavelength region was achieved for the first time in 1992. The reported lasing performance of this polymer was comparable to that of the most efficient laser dye Rhodamine 6G.

The most efficient known light-emitting polymeric systems are based on poly(p-phenylene-vinylene) (PPV) films which emit basically green light (11). However, there is still a big challenge in obtaining highly efficient blue light emitting devices and lasers, which can also not be made easily out of inorganic materials. Several organic conjugated systems, presenting higher band gaps, suitable for blue light emission were already studied. They include small conjugated molecules (4, 12), poly(p-phenylene) (PP) polymers (13), PPV oligomers dispersed in a polymer matrix (14) or build into a flexible polymer chain (15).

In general it is desirable to be able to vary the emission wavelength of light emitting materials to influence the color of the emitted light. The emission wavelength is a function of the conjugation length in the polymer and of its side-chains. Colortuning may thus be achieved by varying this conjugation length and the side-chains used.

It is the object of the present invention to provide a group of new light emitting polymer materials in which the conjugation length may be easily adapted in order to be able to influence the emission wavelength.

The invention therefore provides new copolymers as defined in claim 1.

According to the invention a copolymer is provided consisting of alternating light emitting units (identified as X) and interruption units (identified as Y or Y'). The interruption units alter the coplanar orientation of the molecule and thereby interrupt the conjugation thus influencing the conjugation length. It has been found that variations in the side-chains of the light emitting unit offer a further possibility for colortuning.

In this application we describe the synthesis, the characterization and the application in light emitting diodes and lasers, of a new blue light emitting, rigid copolymer, poly[2,5,2'',5''-tetraoctyl-p-terphenyl-4,4''-ylene-vinylene-p-phenylene-vinylene], hereafter abbreviated as TOP-PPV, as a representative of the group of compounds according to the invention. Furthermore, various other members of the group have been synthesized and analysed. Table 1 shows their structures. Their optical properties (absorption and emission) in solution (tetrahydrofuran) are listed in Example 7.

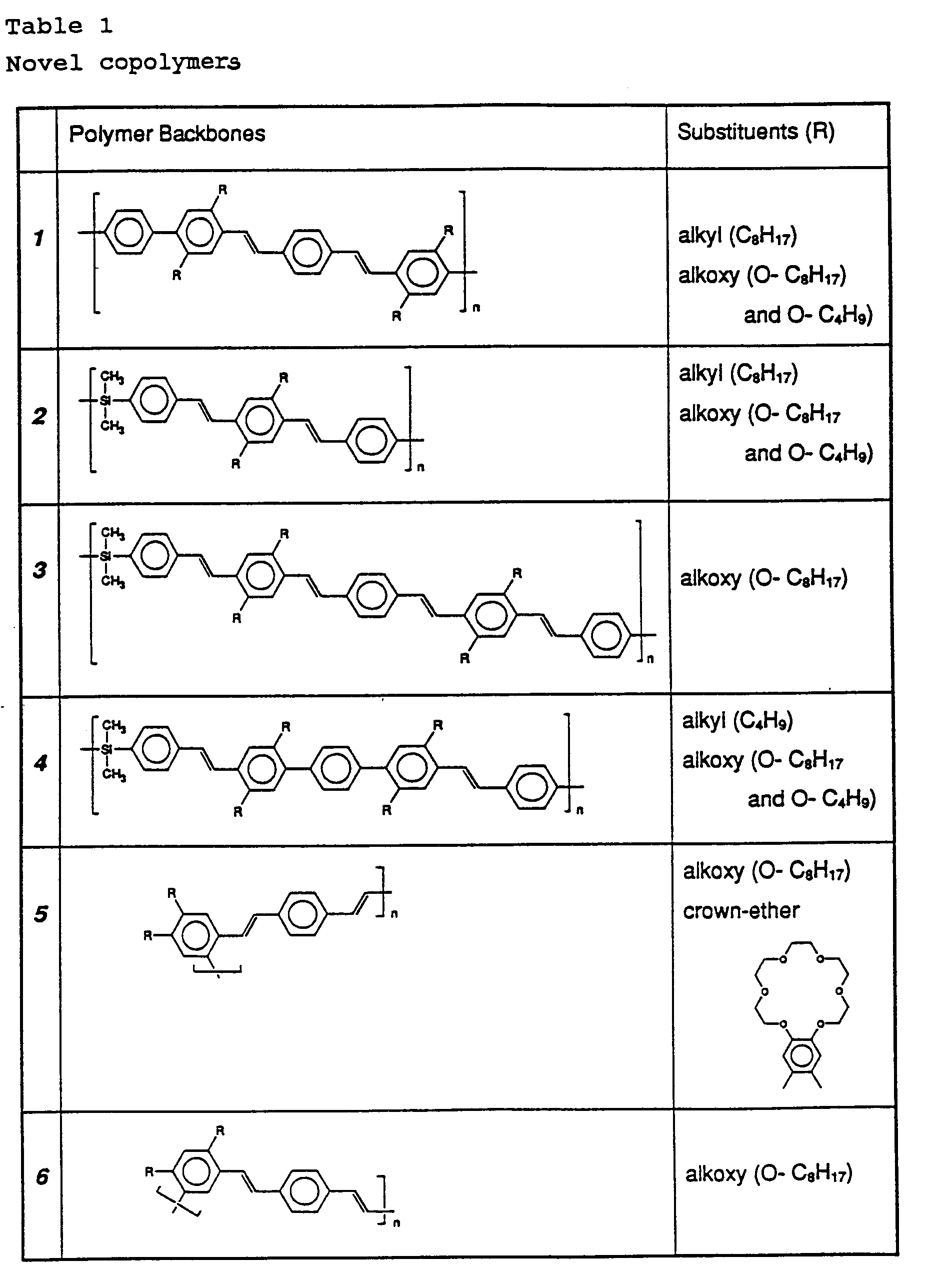

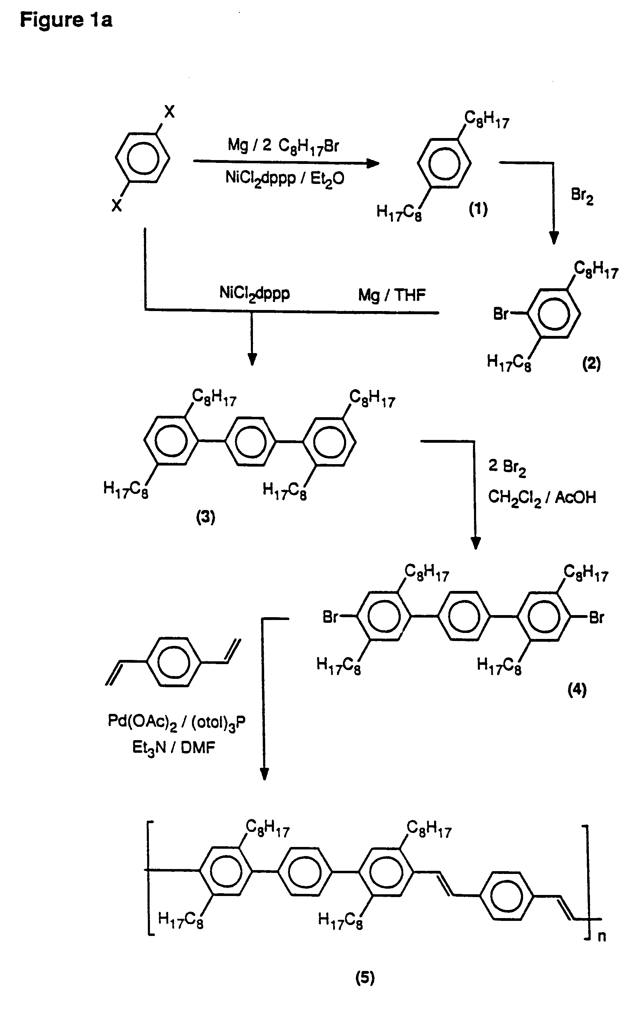

The fully unsatured backbone of the TOP-PPV polymer (Figure 1a) consists of regularly alternating tetraoctyl-terphenylene (TOP) and p-phenylene bisvinylene blocks. In this type of π-aromatic structure, the blue PPV-like chromophores are linked through another conjugated unit presenting a higher bandgap. Solubility of the conjugated form is obtained through the presence of long alkyl side-chains on the terphenylene units.

The synthetic approach to this polymer is sketched in figure 1a. The key intermediate in the synthesis is the dihalogenated, alkyl substituted terphenylene monomer. This compound was obtained through a nickel-catalyzed Grignard coupling (16) between 2-bromo-1,4-dioctylbenzene and p-diiodobenzene. The mono-brominated dioctylbenzene could be obtained by mono-bromination of the dioctylbenzene liquid. The latter was also synthesized from a nickel catalyzed Grignard coupling (16) between dibromobenzene and octylbromide.

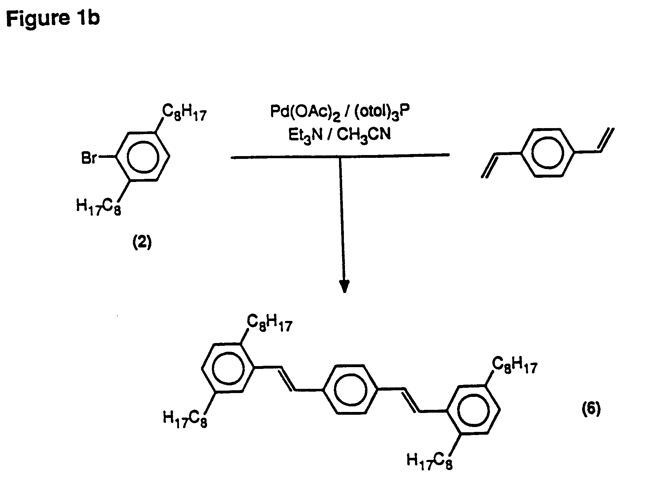

The block copolymer was synthesized via a Heck coupling reaction (17) between the terphenylene monomer and p-divinylbenzene. The Heck coupling (reaction of an organic halide with a vinyl benzene giving a carbon-carbon double bond) was previously shown to have a great potential in polymerization reactions (18, 19, 20), and leads to the formation of pure trans double bonds with very few side reactions. By using the same Heck coupling with two of the intermediate compounds from the copolymer synthesis, namely 2-bromo-1,4-dioctyl-benzene and p-divinylbenzene, a model compound, 1,4-di(2,5-dioctylstyryl)benzene (Figure 1b) could also be obtained. This oligomer, hereafter abbreviated as DDOSB corresponds to the PPV part from the TOP-PPV copolymer.

The TOP-PPV copolymer could be obtained in good yields via Heck coupling, when using the dibrominated terphenylene monomer. This result is surprising since it is known that the Heck reaction is generally more effective with aryl iodides than with aryl bromines. In the present case it turns out that the presence of long aliphatic side-chains in the ortho position of the halide induces a important steric hindrance. Presumably the combination of the long side-chain with the bulky iodine atom results in difficult formation of the organopalladium intermediate (17).

The TOP-PPV and other copolymers of the invention may be used in light-emitting devices, such as diodes (LEDs). To demonstrate this light emitting devices were fabricated as described previously (25). A thin polymer film was used as active layer and was sandwiched between two electrodes. Indium-tin oxide (ITO) was used as a transparent hole injecting anode, and aluminum as an electron injecting cathode. By applying a positive voltage to the ITO, current flows through the device and the emitted blue light can be seen through the transparent ITO and its glass substrate.

The polymer of the invention also appears to be a very efficient blue laser dye in solution. Research that led to the present invention demonstrated for the first time the lasing performance of the novel highly efficient copolymer TOP-PPV in the blue wavelength region. The invention thus provides a dye laser, comprising a laser dye solution disposed in a resonant cavity, comprising a copolymer of the invention such as TOP-PPV, and a non-aqueous solvent, the solvent being substantially unable to chemically react with the copolymer and to absorb and emit light at a wavelength similar to the copolymer, and further comprising a pumping energy source producing stimulated emission in the dye solution. The wavelength of the pumping energy source is preferably about 300 to 600 nm. Using the specific polymers as defined in claims 2-7 the wavelength of the stimulated emission comprises about 400-600 nm.

The solvent is a liquid solvent preferably selected from the group consisting of xylene, methanol, chloroform, toluene, tetrahydrofuran, chlorobenzene, dichlorobenzene and hexane. The copolymer is preferably present in the solution at a concentration of about 0.1 to 10 mg/ml.

The invention further relates to a laser dye solution comprising a copolymer according to the invention, and a non-aqueous solvent, the solvent being substantially unable to chemically react with the copolymer and to absorb and emit light at a wavelength similar to the copolymer.

In another aspect the invention relates to a method of producing a coherent laser emission in the operation of a dye laser in the wavelength range of about 400-600 nm comprising placing in an optically resonant cavity and optically pumping a laser dye solution, comprising a copolymer of the invention, to produce a population inversion in the laser dye solution with resulting stimulated emission.

In a further aspect of the invention a polymer optical fiber amplifier is provided, wherein the organic dye doped in the polymer optical fiber is the copolymer of the invention. The principle of polymer optical fiber amplifiers is for example described in reference 41. In such a POFA the copolymer may be dispersed in a polymer matrix forming a wave guide or fibre.

The invention also relates to a solid state dye laser, comprising a pure copolymer of the invention or such a copolymer dispersed in an appropriate polymer matrix. The principle of solid state dye lasers is known to the skilled person.

In a last aspect the invention provides a microcavity LED, comprising the copolymer as such or in a suitable solid medium sandwiched between two flat reflecting electrodes (Fabry-Perot configuration) serving also for the injection of holes and electrons.

The present invention will be further elucidated in the following Examples with reference to the figures. The Examples are incorporated for illustration purposes only and are in no way to be construed as limiting the invention.

In the Examples the following materials were used. Diethylether was distilled successively over phosphorus pentoxyde (P₂O₅) and lithium aluminum hydride (LiAlH₄), tetrahydrofuran (THF) was distilled over LiAlH₄. Triethylamine was dried over potassium hydroxyde (KOH). Other solvents were used as such (P.A. grade). 1-bromo-octane, 1,4-dibromobenzene, 1,4-diiodobenzene, palladium acetate (Pd(OAc)₂), tri-o-tolylphosphine were used as received (Janssen Chimica or Aldich Chemicals). Dichloro[1,3--bis(diphenylphosphino)-propane]-nickel(II) (NiCl₂[dppp]) was synthesized according to the literature (31). Pure p-divinylbenzene was isolated from a commercial mixture of isomers following the literature procedure (32). All reactions were carried out under a dry argon atmosphere.

### EXAMPLES

### Example 1

### Monomer synthesis

### 1. 1,4-dioctylbenzene (1)

A solution of 1-bromo-octane (385.8 g, 2.0 mol) in diethylether (300 ml) was added slowly to magnesium turnings (72.9 g, 3.0 mol) in diethylether (450 ml). The reaction mixture was refluxed for 1 hour. The obtained Grignard reagent was added slowly at room temperature to a solution of 1,4-dibromo-benzene (189.0 g, 0.8 mol) and NiCl₂[dppp] (0.5 g) in dry diethylether (600 ml) at such a rate to maintain gentle boiling of the ether. After addition of another portion of NiCl₂[dppp] (100 mg) stirring was continued for two days at 30°C. The reaction mixture was poured into a cold 5% aqueous HCl solution (1 L). after separating the layers, the water layer was extracted with diethylether and the combined ether layers were dried over MgSO₄, filtered and the solvent removed by evaporation. Vacuum distillation (168°C/0.4 mbar) of the crude product provided the pure title product (162.5 g / 67%).

¹H NMR 0.93(t, C*H*₃, 6H),1.33 (m, C*H*₂, 20H), 1.65 (m, β-C*H*₂, 4H), 2.61 (t, -C*H*₂, 4H), 7.14 (s, arom. C*H*, 4H); ¹³C NMR 14.2 (*C*H₃). 22.8, 29.4, 29.5, 29.6, 31.7, 32.0, 35.7 (*C*H₂), 128.3 (arom. *C*H), 140.1 (arom. *C*).

### 2. 2-bromo-1,4-dioctylbenzene (2)

Bromine (86.4 g, 054 mol was added dropwise to a mixture of 1,4-dioctylbenzene (162.5 g, 0.54 mol) and iodine (0.23 g, 1.84 mol), under exclusion of light at room temperature. After stirring overnight the reaction mixture was poured into an aqueous solution (500 ml) of 20% KOH and 10% sodiumthiosulfate. Stirring was continued until the color disappeared (ca. 5 min.). The aqueous solution was extracted with diethylether (2300 ml). The organic layer was dried over MgSO₄, filtered and the solvent was removed by evaporation. Kugelrohr distillation (185°C/0.1 mbar) of the residue provided the title product (172.5 g / 85%).

¹H NMR 0.91 (t, C*H*₃, 6H), 1.30 (m, C*H*₂, 20H), 1.59 (m, β-C*H*₂, 4H), 2.56/2.70 (m, -C*H*₂, 4H), 7.04 (dd, arom. *C*H, 1H), 7.13 (dd, *C*H, 1H), 7.37 (s, *C*H, 1H); ¹³C NMR 14.0 (*C*H₃), 22.6, 29.1, 29.2, 29.3, 29.9, 31.2, 31.8 (*C*H₂), 127.3, 130.0, 132.3 (arom. *C*H), 124.1, 139.0, 142.2 (arom. *C*).

### 3. 2,5,2'',5''-tetraoctyl-p-terphenylane (3)

2-Bromo-1,4-dioctylbenzene (175.2 g, 0.46 mol) was added dropwise to magnesium turnings (16.77 g, 0.69 mol) in boiling THF (50 ml). The reaction mixture was refluxed for an half hour. The Grignard reagent was then added dropwise to a solution of p-diiodobenzene (60.7 g, 0.18 mol) and NiCl₂[dppp] (0.5 g) in THF (1 L). When addition was complete, stirring was continued for two days at 40°C. The reaction mixture was poured into a cold 5% aqueous HCl solution (500 ml). After separating the layers, the water layer was extracted with diethylether (2200 ml). The combined organic layers were dried over MgSO₄, filtered and the solvent removed by evaporation. The crude product was recrystallized twice from a methanol/diethylether (1/3) mixture, giving the title product (59.7 g / 48%).

¹H NMR 0.86 (t, C*H*₃, 12H), 1.21/1.29 (m, C*H*₂, 40H), 1.56 (m, β-C*H*₂, 8H), 2.61 (t, -C*H*₂, 8H), 7.13 (s, arom. C*H*, 2H), 7.20 (s, arom. C*H*, 4H), 7.36 (s, arom. C*H*, 2H); ¹³C NMR 14.1 (*C*H₃). 22.6, 29.2, 29.3, 29.5, 31.6, 32.7, 35.6 (*C*H₂), 127.2, 128.8, 129.1, 130.1 (arom. *C*H), 137.6, 140.1, 140.5, 141.4 (arom. *C*). Exact mass. calcd. for C₅₀H₇₈ 677.91, measd. 677.91. Anal. Calcd. for C₅₀H₇₈: C: 88.42; H: 11.58. Found: C: 87.99; H: 11.68. m.p. 56-58 °C

### 4. 4,4''-dibromo-2,5,2'',5''-tetraoctyl-p-terphenylene (4)

Bromine 6.6 g, 41.2 mmol) was added carefully to a mixture of 2,5,2'',5''-tetraoctyl-p-terphenylene (12.7 g, 18.7 mmol) and a few crystals of iodine in dichlormethane (50 ml) and glacial acetic acid (15 ml) under exclusion of light. After one night of stirring the reaction mixture was poured into an aqueous solution (20 ml) of 20% KOH and 10% sodiumthiosulfate. Stirring was continued until the color disappeared. Layers were separated and the aqueous solution was extracted with dichlormethane. The combined organic layers were dried over MgSO₄, filtered and the solvent was removed by evaporation. Recrystallization from diethylether afforded the pure monomer (8.0 g / 51%).

¹H NMR 0.87 (t, C*H*₃, 12H), 1.21/1.29 (m, C*H*₂, 40H), 1.61 (m, β-C*H*₂, 8H), 2.56 (t, -C*H*₂, 4H), 2.73 (t, -*C*H₂, 4H), 7.11 (s, arom. C*H*, 2H), 7.31 (s, arom. C*H*, 4H), 7.47 (s, arom. C*H*, 2H); ¹³C NMR 14.0 (*C*H₃), 22.6, 29.2, 29.4, 29.5, 31.6, 32.7, 35.6 (*C*H₂), 123.2 (arom. *C*-Br), 128.7, 131.5, 133.0 (arom. *C*H), 139.1, 139.6, 139.7, 140.6 (arom. *C*).Exact mass to high to be measured. Anal. Calcd. for C₅₀H₇₆Br₂: C: 71.75; H: 9.15, Br: 19.09. Found: C: 70.60; H: 8.90, Br: 19.94. m.p. 79-80 °C

### Example 2

### Polymer synthesis

### Poly[2,5,2'',5''-tetraoctyl-p-terphenyl-4,4''-ylene-vinylene-p- phenylene-vinylene] (5)

A mixture of monomer 4 (1.0 g, 1.2 mmol), p-divinylbenzene (0.155 g, 1.2 mmol), Pd(OAc)₂ (0.011 g, 0.05 mmol), tri-o-tolylphosphine (0.071 g, 0.23 mmol), triethylamine (2 ml) and DMF (5 ml) was placed in a heavy-wall pressure tube. The tube was degassed, then closed (Teflon bushing) and heated to 100°C. After 40 h of reaction thin layer chromatography showed that the monomers were consumed. The reaction mixture was then poured into methanol (75 ml). The precipitated material was filtered off and dried under vacuum, giving a brown-yellow polymer (0.88 g, conversion = 91%). The crude polymer was dissolved in chloroform and then filtered through a small column of Kieselgel, in order to remove traces of catalyst. The resulting solution was concentrated and precipitated in methanol (75 ml). The yellow polymer was collected by filtration and thoroughly dried under vacuum.

¹H NMR (broad signals) 0.89 (t, C*H*₃, 12H), 1.25/1.29/1.5 (m, C*H*₂, 48H), 2.64 (m, - C*H*₂, 8H), 7.1-7.6 (3 main peaks, arom. C*H* and vinyl C*H*, 16H), ¹³C NMR 14.1 (*C*H₃), 22.6, 29.2, 29.3, 29.5, 31.8, 32.7, 35.6 (*C*H₂), 126.4, 126.8, 128.8, 129.2, 130.1, 131.5 (arom. *C*H), 134.7, 137.2, 137.6, 138.1, 138.2, 140.1 (arom. *C*). Calcd. for C₆₀H₈₄ (repeating unit) C: 89.49; H: 10.51. Found: C: 88.02; H: 10.51; Br: 0.89.

### Example 3

### Model compound synthesis

### 1,4-di(2,5-dioctylstyryl)benzene (6)

A mixture of 2-bromo-1,4-dioctylbenzene (compound 2) (1.7 g, 4.5 mmol), p-divinylbenzene (0.25 g, 1.9 mmol), Pd(OAc)₂ (0.020 g, 0.09 mmol), tri-o-tolylphosphine (0.060 g, 020 mmol), triethylamine (2 ml) and acetonitrile (5 ml) was placed in a heavy-wall pressure tube. The tube was degassed, then closed (Teflon bushing) and heated to 100°C. After 40 hours the reaction mixture was poured into 5% aqueous HCl (100 ml). the solution was extracted with chloroform (3x50 ml). The combined organic layers were dried over MgSO₄, filtered and the solvent was removed by evaporation. Recrystallization from hexane afforded the pure compound (0.616 g / 44%).

¹H NMR 091(t,*C*H₃,12H), 1.30(m, C*H*₂, 40H), 1.63 (m, β-C*H*₂, 8H), 2.64 (t, -C*H*₂, 4H), 2.75 (t, -C*H*₂, 4H), 6.99/7.14 (m, 6H comprises 1d, olef. C*H*, 2H and 2d, arom. C*H*, 4H), 7.37/7.45 (m, 4H comprises 1d, olef. C*H*, 2H and Id, arom. C*H*, 2H), 7.55 (s, arom. C*H*, 4H); ¹³C NMR 14.1 (*C*H₃), 22.6, 29.3, 29.5, 29.6, 31.3, 31.6, 31.9, 33.1, 35.7 (*C*H₂), 125.5, 126.4, 126.8, 127.8, 129.1, 129.6 (arom. *C*H), 135.5, 137.1, 138.0, 140.6 (arom. *C*). Anal. Calcd. for C₅₄H₈₂: C: 88.70; H: 11.30. Found: C: 88.50; H: 11.50. m.p. 46-47 °C.

### Example 4

### Characterization of the TOP-PPV block copolymer

### 1. Measurements

NMR-spectra were collected on a Varian (VXR 300) spectrometer with chloroform-d as solvent and internal standard. IR-spectra were recorded on a Mattson Instruments FT-IR spectrometer. UV-spectra were recorded on a SLM AMINO 3000 Array spectrophotometer. Fluorescence was measured on a SLM Amino SPF-500 spectrofluorometer. The Gel Permeation Chromatography (GPC) measurements were performed on a Spectra Physics 1000 system equipped with a Viscotek H502 viscometer and a Shodex RI-71 refractive index detector coupled to a Dawn light scattering apparatus; polystyrene standards were used for calibration. Thermogravimetric analysis was performed on a Perkin-Elmer Thermal Analysis System 7. Differential Scanning Calorimetry thermograms were recorded on a Perkin-Elmer DSC7.

### 2. Results

Gel Permeation Chromatography measurements with THF as eluent indicated M_{W} = 4500 (M_{W}/Mₙ = 1.7) for the TOP-PPV copolymer as prepared in Example 2. This molecular weight appears to be relatively low, identically to what has been observed in other polymerizations of this type (18,19). It shows that the reaction is rather slow and that the oligomers formed probably become less and less reactive during their growth until they eventually precipitate. Optimization of the reaction conditions and alternative synthetic routes may lead to higher molecular weights.

The solubility of TOP-PPV is very good in common organic solvents such as tetrahydrofuran, chloroform or toluene. Casting or spin coating from solution produces homogeneous, pin-hole free thin films, as evidenced by the realization of operational LEDs (see Example 5).

NMR spectra of the copolymer are globally consistent with the expected repeating unit. In the ¹H NMR spectrum all the aromatic peaks are between 7 and 8 ppm. The absence of peaks at about 6.5 ppm indicate that no cis vinylene bonds are present. Since the molecular weight is low, small peaks corresponding to vinyl end groups can be seen at 5.3 and 5.9 ppm. In the ¹³C NMR spectrum a few small extra peaks are also observed in the aromatic region, which render exact assignment difficult. Elemental analysis indicates the presence of some bromine (0.89%) corresponding to terphenylene end groups.

Infrared spectroscopy spectra of the TOP-PPV copolymer show a peak at 960 cm⁻¹ that corresponds to the stretching of trans-vinylene bonds (21), whereas no peak corresponding to the stretching of cis-vinylene bonds (21) can be seen in the 890-900 cm⁻¹ region. This clearly confirms that only trans double bonds are formed by the Heck reaction.

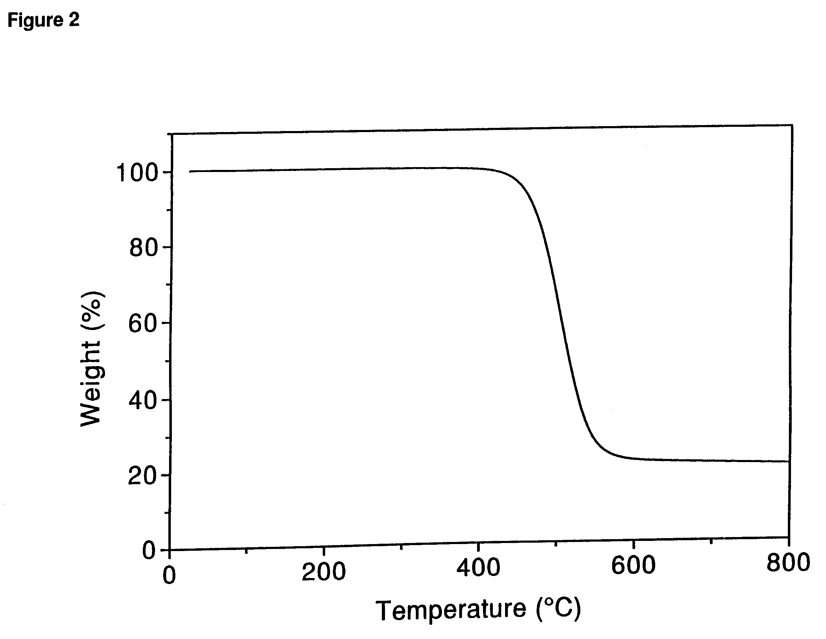

Thermogravimetric analysis (TGA) revealed a very good thermal stability, up to 420°C under nitrogen (Figure 2). This is similar to the stability observed in substituted PPV's (20). Differential Scanning Calorimetry (DSC) thermograms show a glass transition at -20°C and melting of the side-chains at 50°C. Those results are consistent with the structure of the copolymer i.e. presence of octyl side-chains and relatively low molecular weight. Increase of the T_{g} can be achieved by decreasing the length of the side-chains (but with drop of the solubility) and/or by obtaining higher molecular weight.

The optical properties of this new copolymer are of primary importance for the invention. A first step in the charcterization of the copolymer is therefore the study of the absorption and emission features in solution.

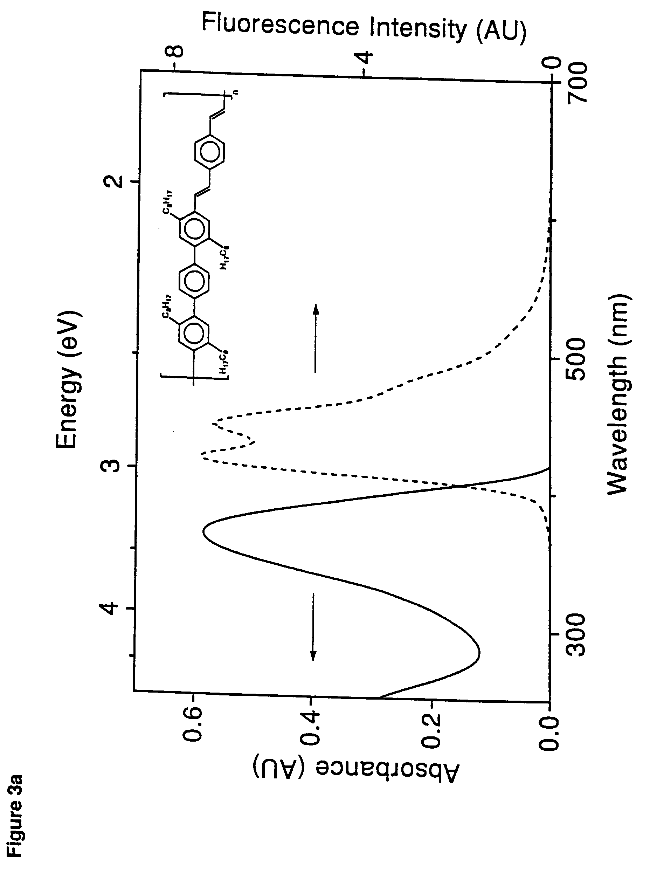

The UV-Visible absorption spectrum of TOP-PPV in THF solution has a maximum at 365 nm (Figure 3a). The solutions show very intense blue fluorescence with maxima at 422 nm and 446 nm (Figure 3a). The fluorescence quantum yield was measured as Φ = 0.8 (excitation at 360 nm). In a non polar solvent like hexane, absorption and emission are 6 nm blue shifted, and the quantum yield goes even up to Φ = 0.9.

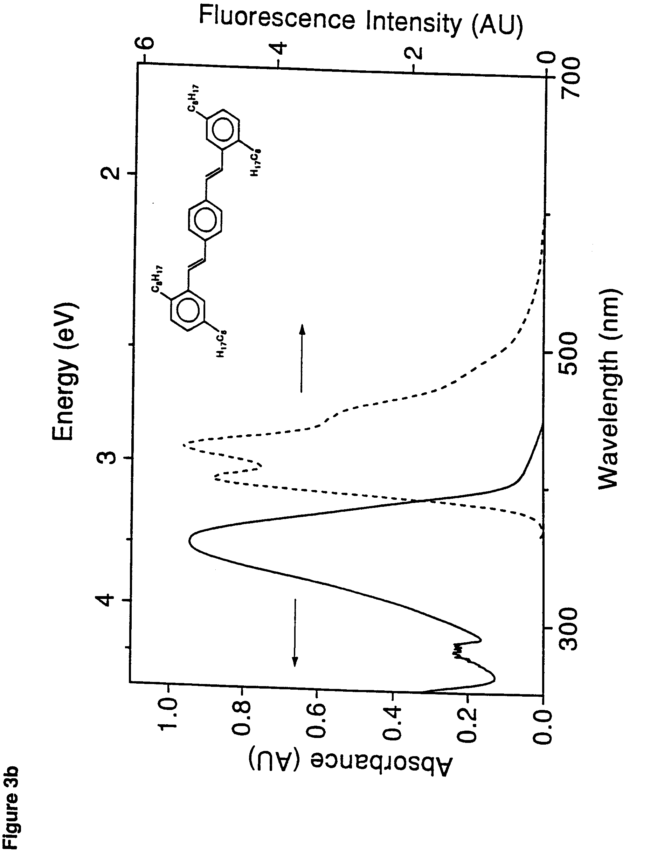

The absorption, emission and quantum yield of TOP-PPV are comparable to those generally observed for substituted PPV oligomers (22). Those features were measured for the model compound DDOSB. In THF solution the absorption maximum is at 355 nm and two emission bands are visible at 400 and 420 nm (Figure 3b). The fluorescence quantum yield is Φ = 0.8. There is a striking similarity between the optical properties of the TOP-PPV copolymer and the DDOSB model compound. The fluorescence quantum yields appear to be exactly the same and the absorption and emission peaks of the copolymer are simply 10-20 nm red shifted when compared to the oligomer.

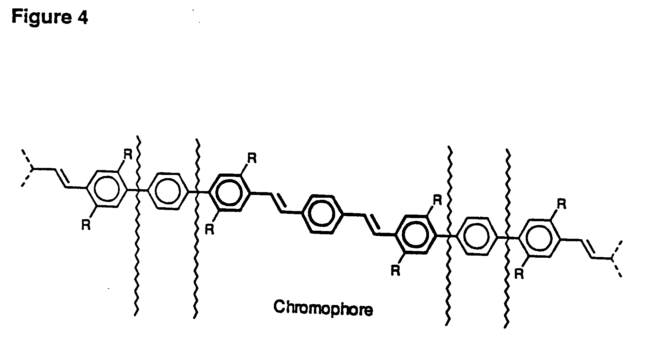

Those results confirm that the active chromophores in the copolymer are the PPV blocks (Figure 4). The interruption of the conjugation can be understood by considering the steric interactions on the copolymer backbone. It is known that even in non substituted polyphenylenes, two adjacent phenyl rings are not coplanar (23). Steric hindrance between the protons of the phenyls induces a twist of about 23°, which still enables a reasonable overlap of the π orbitals. The presence of bulky side-chains, like the octyl chains here, is responsible for a much larger twist angle between the phenyl rings, disabling the possibility of conjugation through the three consecutive phenyl rings from the terphenylene in the copolymer of the invention. So the conjugation of the fully unsaturated backbone is regularly interrupted, resulting in well defined PPV chromophores connected to each other by non coplanar phenylene groups. A very interesting point is that in this copolymer structure the photoluminescence efficiency in solution does not drop when compared to that of the chromophore molecules.

### Example 5

### Light emitting devices

A thin polymer film (50-75 nm) was spin coated (1000-5000 rpm) from a filtered (10 µm filter) toluene solution (3%) on an indium-tin oxide coated glass substrate. An aluminum electrode was evaporated (vacuum below 10⁻⁶ mbar) on top of the polymer film with a mask. All fabrication steps were performed in clean room conditions. For photoluminescence studies of thin films the polymer was spin coated from the same solutions on glass slides.

Film thickness were measured with a Sloan Dektak 2030 ST Surface Texture Analysis System. Electroluminescence measurements (I-V-L and quantum efficiencies) were performed on a system comprising a Keithley 236 Source-Measure Unit coupled to a sample holder, and a Labsphere integrating sphere with a calibrated silicon photo-diode coupled to a SR400 photon counter. Measurements were done at room temperature in air.

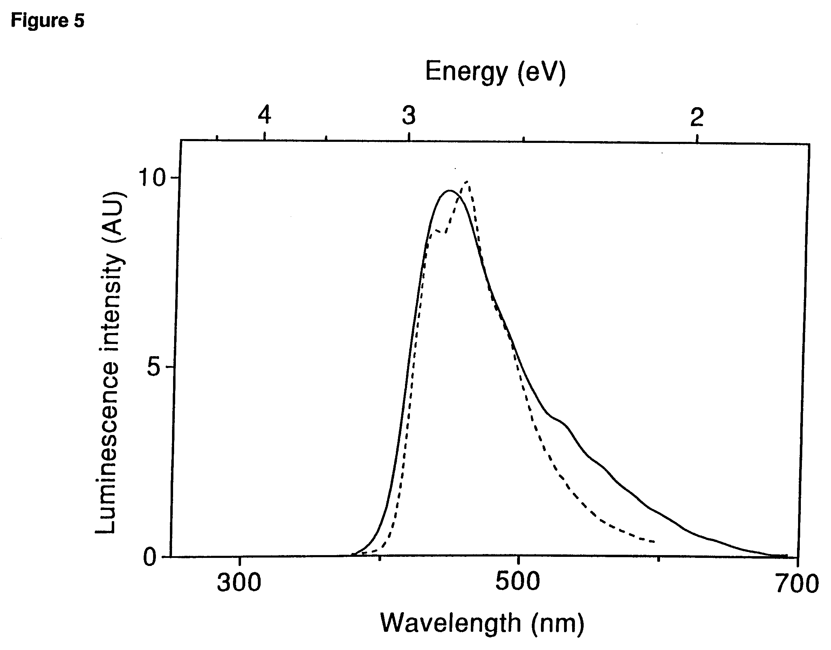

Figure 5 shows the photoluminescence spectrum of a thin film of TOP-PPV and the electroluminescence spectrum of an ITO/TOP-PPV/A1 device. The two spectra are almost similar, indicating that the same excited states are involved in the two processes. The emission is centered at about 440 nm, which is slightly red shifted when compared to the photoluminescence from solutions.

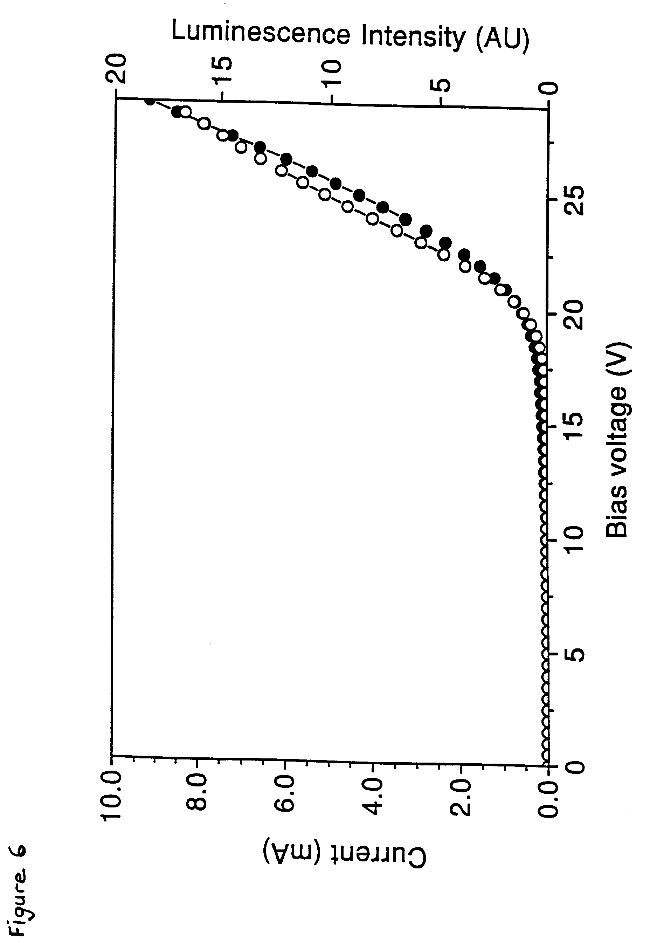

Figure 6 represents typical current-voltage and luminescence-voltage measurements in a device. Current and light arise at almost the same voltage which is increasing with the film thickness (26). The device measured in figure 6 shows a turn-on voltage of 17.5 volts obtained in a 70 nm thick film, corresponding to a field of 2.5E10⁸ V/m. This turn-on voltage is relatively high but is consistent with the fact that we deal with a high band-gap polymer in which it is difficult to inject charges. Furthermore a non optimized device configuration was used here.

The external efficiency of the devices was measured in an integrating sphere and found to be in the range of 10⁻² % photons/electrons. The highest value obtained was 0.03 % photons/electrons. Those efficiencies appear to be low but the result has to be tempered since external quantum efficiencies are measured on non-optimized devices. To optimize the devices the use of a metal with a lower work function (calcium or magnesium for example) known to facilitate the injection of electrons (27, 28, 29) might be considered, and/or the devices may be realized with multi-layer structures including additional charge injection and transport layers (4, 11, 12, 30).

### Example 6

### Lasing effect

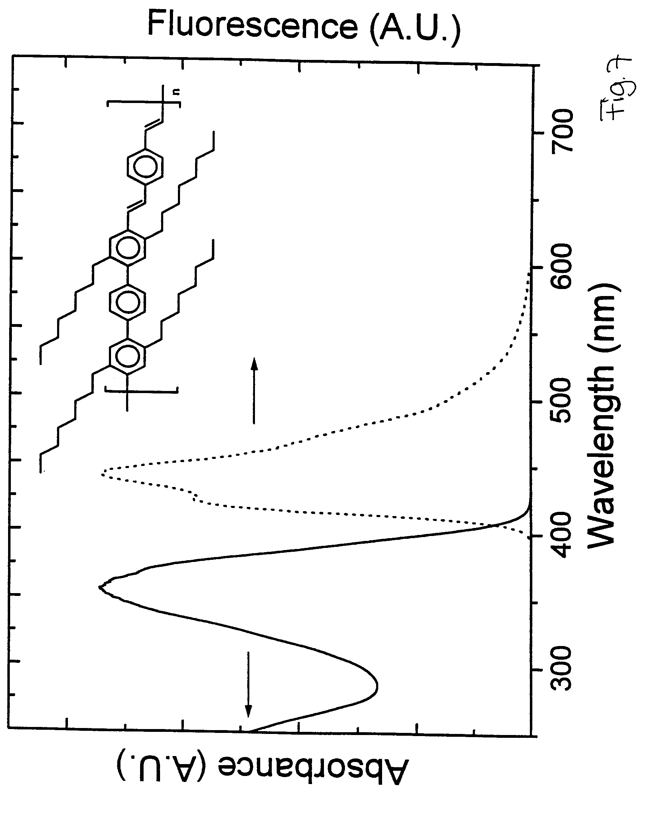

Figure 7 shows the absorbance (λₘₐₓ = 357 nm) and emission (λₘₐₓ = 440 nm) spectra of a solution of the TOP-PPV copolymer in hexane (10 mm quartz cell). Photoluminescence quantum yields as high as Φ_{F} about 0.8-0.9 were obtained in solution (THF, hexane) which gave a clear indication of the possibility of lasing action.

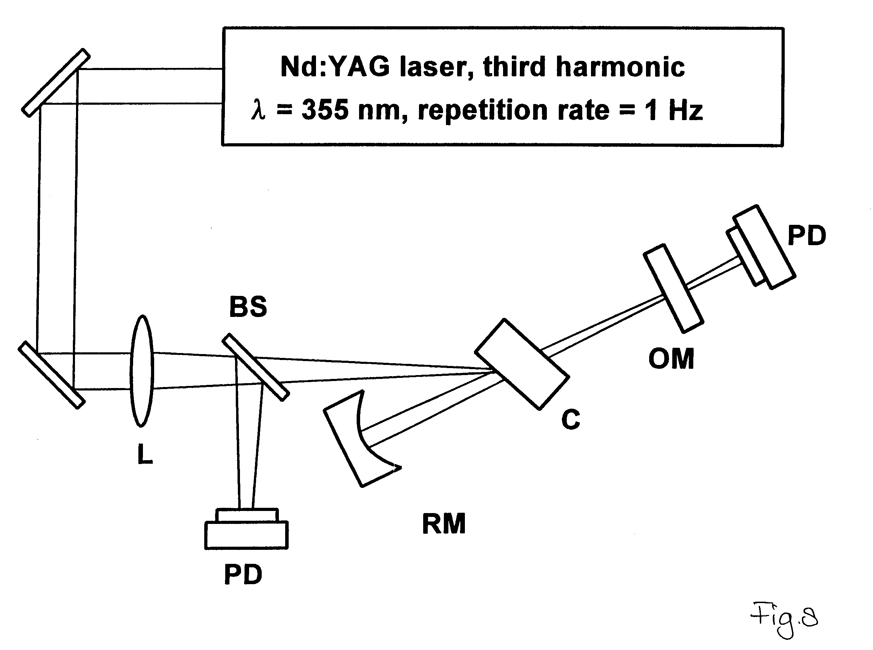

In order to test the lasing effect energy conversion efficiency measurements were performed using a linear non dispersive cavity in a quasi-longitudinal pumping arrangement. The experimental setup is schematically depicted in figure 8. The cavity is defined by a concave metallic rear mirror and a flat dielectric output coupler (transmittance T = 81%, λ - 360 - 460 nm) separated by a distance of 95 mm. The pump source was a Nd:YAG laser, Quanta-Ray GCR 130-50, operating at tripled frequency (λ - 355 nm, p-polarized, pulse width = 8 ns) with a repetition rate of 1 Hz. In order to prevent laser generation from the cell walls and to minimize Frensel losses, the dye cell (pathlenght 10 mm) was tilted with respect to the pumping beam. The angle between the pumping and generated beam was approximately 7°. The input and output pulse energy was monitored with two calibrated pyroelectric detectors (Coherent LMP 5, Molectron J3-O2 respectively). The spectral characteristics of the laser and luminescence output were measured with an Optical Multichannel Analyzer (Princeton Instruments).

In the case of tuning range measurements a quartz prism was incorporated between the rear mirror and the dye cell as a dispersive element. Wavelength tuning was achieved by rotation of the rear mirror.

The lasing performance of TOP-PPV was studied in three solvents: tetrahydrofuran, hexane and p-xylene (Merck, spectroscopic grade). In the case of hexane (a poor solvent for TOP-PPV) the solution was filtered over an 0.2 µm filter to remove undissolved compound. The reference laser dyes Coumarin 120 and 47 (Lambdachrome LC 4400 and LG 4700) were used in ethanol solution (Merck, spectroscopic grade). All prepared solutions had a transmittance of 1% at λ - 355 nm, measured in a standard 10 mm quartz cuvette on a SLM amino 3000 diode array spectrometer. Concentration dependent measurements at fixed pump energy indicated that the transmittance (T=1%) of the dye solutions were in the region of optimum efficiency.

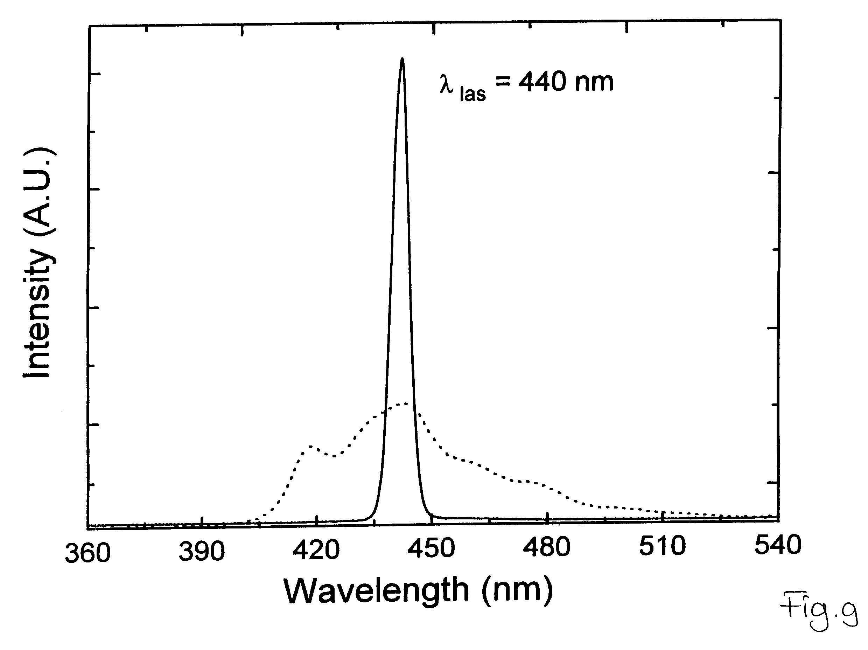

Clear evidence of laser action of the TOP-PPV copolymer is shown in figure 9. When the pump energy exceeds the treshold energy of lasing, intense blue light with a narrow spectral bandwidth (7 nm, FWHM) was emerging from the output coupler. The spectrum of the spontaneous emission was obtained after blocking the rear mirror of the cavity to interrupt the feedback system. The wavelength of laser generation coincides with the maximum of the fluorescence emission spectrum.

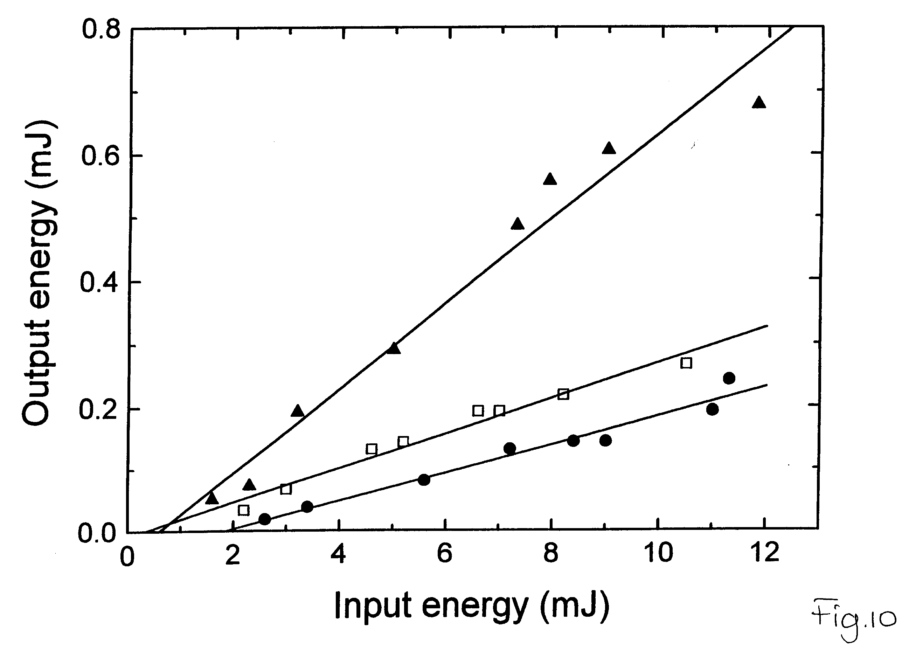

Figure 10 shows the ordinary linear dependence of the output pulse energy of the dyes as function of the input pulse energy of the Nd:YAG laser. This plot clearly demonstrates that the conversion efficiency (7%) of TOP-PPV in hexane is significantly higher than in all other cases. The conversion efficiencies and lasing wavelengths for all dyes are given in table 2. The efficiencies of TOP-PPV in THF and p-xylene (1.8 and 2.8% resp.) are comparable to that of the coumarine dyes. As expected the lasing wavelength for TOP-PPV in THF and p-xylene are red shifted (bathochromic shift) with respect to hexane due to increasing solvent polarity. The lasing bandwidth of the TOP-PPV polymer was approximately 7 nm in all solvents. The bandwidth of both coumarin dyes was almost twice larger, 12 nm. During all measurements no visible signs of photodegradation were observed.

The results of the wavelength tunability measurements are shown in table 2.

**Table 2**

| dye | solvent | λₗₐₛ (nm)^{a} | efficiency (%)^{a} | tuning range (nm)^{b} |
|---|---|---|---|---|
| TOP-PPV | THF | 449 | 1.8 | 438-456 |
| TOP-PPV | p-xylene | 449 | 2.8 | 436-456 |
| TOP-PPV | hexane | 440 | 6.8 | 414-452 |
| Coumarin 47 | ethanol | 451 | 2.8 | 444-470 |
| Coumarin 120 | ethanol | 439 | 2.3 | 424-450 |

| | | | | |
|---|---|---|---|---|
| ^{a}linaer non dispersive cavity, | | | | |
| ^{b} dispersive cavity | | | | |

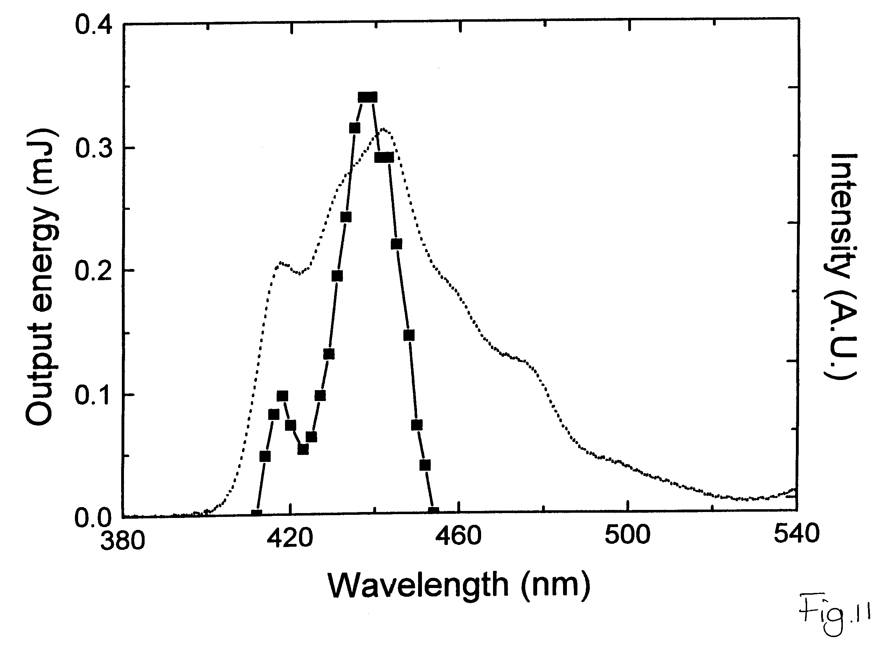

For the TOP-PPV copolymer in hexane the tuning curve and the fluorescence spectrum are plotted in figure 11. From this plot it can be seen that the tuning curve follows the shape of the emission spectrum in the wavelength region with the highest emission cross section (414-452 nm), due to the small overlap between absorbance and emission band. The wavelength tuning range of TOP-PPV in hexane (Δλ = 38 nm) was the highest among all dye/solvent systems measured, which demonstrated the superior efficiency of this polymer solution. It should be mentioned that the bandwidth of laser generation was 3 nm (FWHM) in all cases and was mainly determined by the dispersion of the cavity. The reason for the higher conversion efficiency of TOP-PPV in hexane is unclear at this moment. Gel Permeation Chromatography (GPC) of the solution revealed that the molecular weight distribution changed with respect to THF and p-xylene. Due to the poor solubility in hexane, only the lower molecular weight species dissolved and as a result the polydispersity (M_{W}/Mₙ) decreased from 1.7 (in THF) to 1.17 (Mₙ = 3,1.10³, M_{W}=3,6.10³).

In conclusion we have demonstrated the performance of a novel high efficiency copolymer laser dye in the blue wavelength region. The conversion efficiency when pumped by third harmonic radiation of a Nd:YAG laser exceeds that of the well known coumarin dyes in this wavelength region. In the case of the TOP-PPV copolymer in hexane a wavelength tuning range of almost 40 nm was obtained. The lasing performance of this polymer shows considerable promise for the development of stable solid state dye doped laser materials based on TOP-PPV.

### Example 7

### Synthesis and characterization of other copolymers of the invention

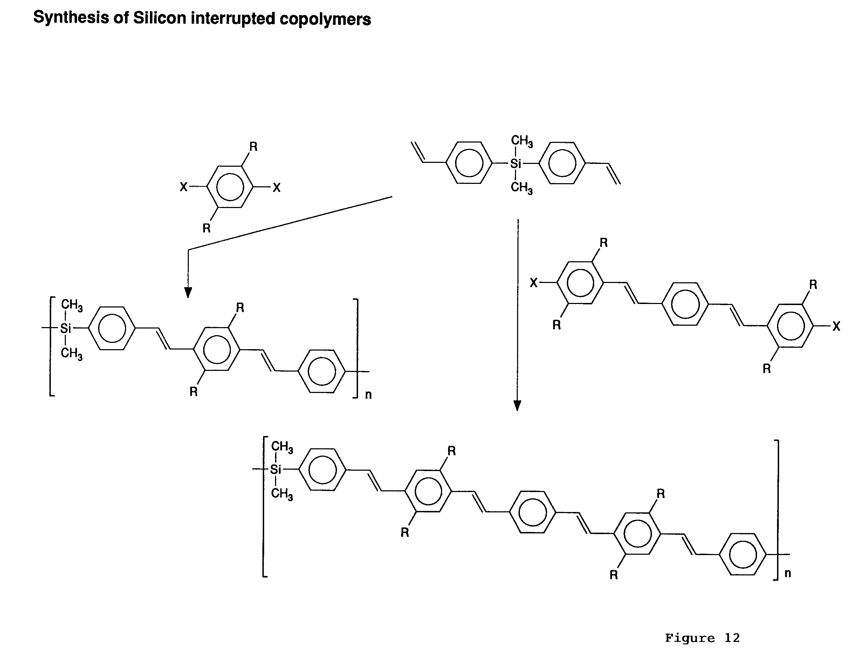

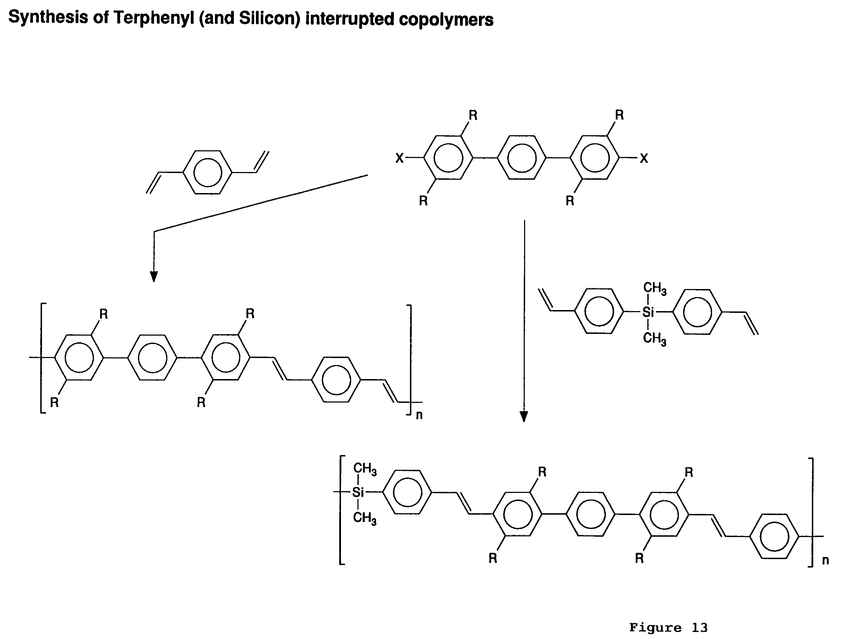

Other corresponding copolymers were synthesized in a similar manner or according to the synthesis pathways described in Fig. 12 for silicon interrupted copolymers and Fig. 13 for terphenyl (and silicon) interrupted coploymers.

The optical properties (absorption and emission) in solution (tetrahydrofuran) of the copolymers thus obtained are listed in Table 3. "Max" represents the maximum absorption and emission wavelenths, and "Φ" is the fluorescence quantum yield.

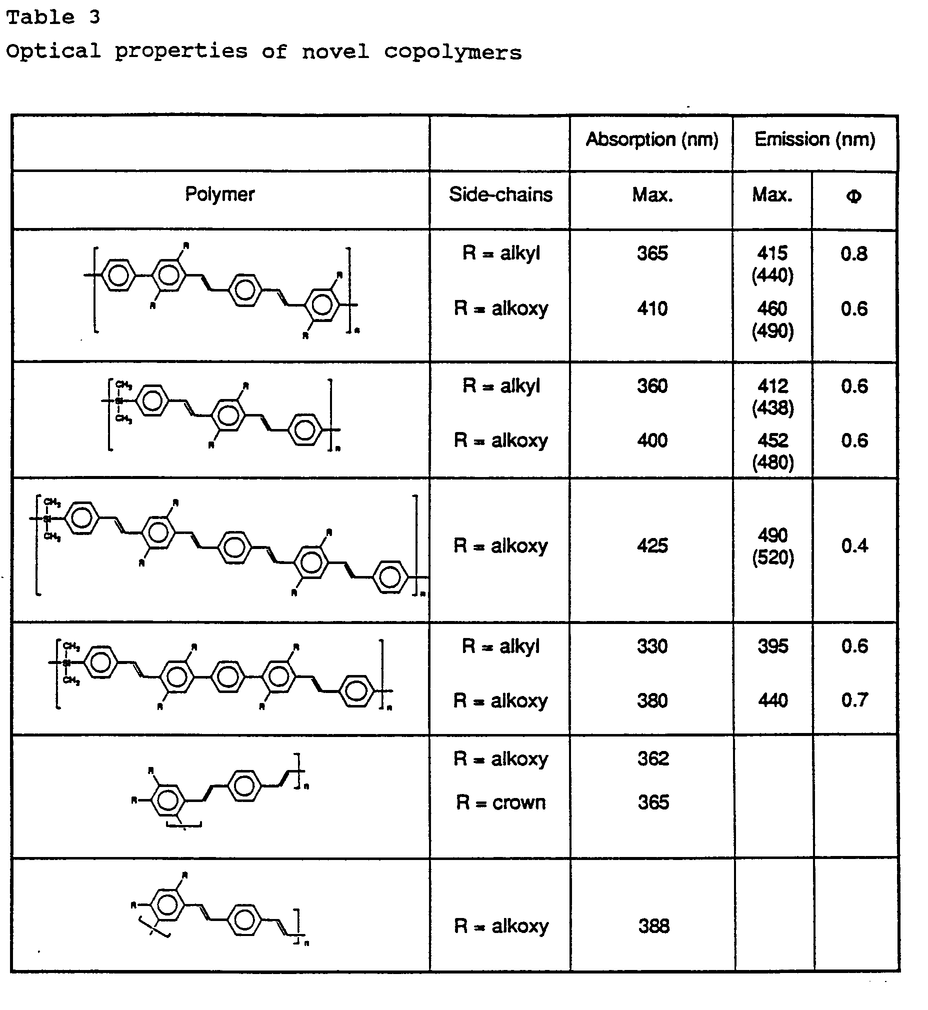

The present invention provides a new group of light-emitting copolymers suitable for a very specific definition of the emission wavelength. In a prefered embodiment the invention provides the novel blue light emitting TOP-PPV copolymer.

### References

1 Kaino, T.; Tomaru, S. *Adv. Mater.* **1993**, *5 (3)*, 172
2 Garito, A.F.; Shi, R.F,; Wu, M. *Physics Today* **1994**, *5*, 51
3 Vincett P.S.; Barlow, W.A.; Hann, R.A.; Roberts, G.G. *Thin Solid Films* **1982**, *94*, 171
4 Adachi, C.; Tsutsui, T.; Saito, S. *Appl. Phys. Lett.* **1989**, *56 (9)*, 799
5 Burroughes, J.H; Bradley, D.C.C; Brown, A.R.: Marks, R.N.; Mackay, K.; Friend R.H.; Burns, P.L; Holmes A.B. *Natur*e **1990**, *347,* 539
6 Braun, D.; Heeger, A.J. *Appl. Phys. Lett.* **1991**, *58 (18)*, 1982
7 Bradley, D.C.C. *Adv. Mater.* **1992**, *4 (11)*, 756
8 Clery, D. *Science* **1994**, *263*, 1700
9 Gill, R.E.; Malliaras, G.G.; Wildeman, J.; Hadziioannou, G. *Adv. Mater*. **1994**, *6 (2)*, 132
10 Malliaras, G.G.; Herrema, J.K; Wildeman, J.; Wieringa, R.H.; Gill, R.E.; Lampoura, S.S.; Hadziioannou, G. *Adv. Mater*. **1993**, *5 (10),* 721
11 Greenham, N.C; Moratti, S.C.; Bradley, D.C.C.; Friend, R.H.; Holmes, A.B. *Nature* **1993**, *365,* 628
12 Adachi, C;Tsutsui, T.; Saito, S. *Appl. Phys. Lett.* **1990**, *57 (6)*, 531
13 Grem. G.; Leditzky, G.; Ullrich, B.; Leising, G. *Synth. Met.* **1992**, *51,* 383
14 Tachelet, W.; Jacobs, S.; Ndayikengurukiye, H; Geise, H.J. *Appl. Phys. Lett.* **1994**, *64 (18),* 2364
15 Yang, Z.; Sokolik, L; Karasz, FE. *Macromolecule*s **1993**, *26*, 1188
16 Tamao, K; Kodama, S.; Nakajima, I.; Kumada, M. *Tetrahedron* **1982**, *38 (22)*, 3347
17 Heck, R.E. *Org. Reac*. **1982**, *27*, 345
18 Heitz, W.; Brugging, W.; Freund, L.; Gailberger, M.; Greiner, A; Jung, H; Kampschulte, U.; Niessner, N.; Osan, F.; Schmidt, H-W.; Wicker, M. *Makromol. Chem.* **1988**, *189*, 119
19 Weitzel, H-P.; Mullen, K. *Makromol. Chem.* **1990**, *191*, 2837
20 Bao, Z.; Chen, Y.; Cai, R; Yu, L. *Macromolecules* **1993**, *26*, 5281
21 Hörhold, H-H., Opfermann J. *Macromol. Chem*. **1970**, *131*, 105
22 Nakatsuji, S.; Matsuda; K.; Uesugi, Y.; Nakashima, K; Akiyama. S,; Katzer, G,; Fabian, W. J. *Chem. Soc. Perkin Trans. 2* **1991**, 861
23 Tour, J.M. *Adv. Mater*. **1994**, *6 (3),* 190
24 Brouwer, H.J.; Krasnikov, V.V.; Hilberer, A; Wildeman, J.; Hadziioannou, G. *Appl. Phys. Lett.* (accepted)
25 Braun, D.; Heeger, A.J.; Kroemer, H. J. *Elec. Mat.* **1991**, *20,* 945
26 Brouwer, H.J.; Hilberer, A.; Hadziioannou, G. *to be published*
27 Parker, I.D. *J. Appl. Phys*. **1994**, *75,* 1656
28 Grüner, J.; Hamer, PJ.; Friend, R; Huber, H.-J.; Scherf, U.; Holmes, AB. *Adv. Mater.* **1994**, *6 (10)*, 748
29 Hsieh, B.R.; Antoniadis, H; Bland, D.C.; Feld, W.A*. Adv. Mater.* **1995**, *7 (1),* 36
30 Kido, J.; Hongawa, K; Nagai, K. *Macromol. Symp*. **1994**, *84,* 81
31 Van Hecke, G.R; Horrocks Jr, W. DeW. *Inorg. Chem.* **1966**, *5,* 1968
32 Storey, B.T. *J. Polym. Sci*. A **1965**, *3,* 265
33 J.H. Burroughes, D.D.C. Bradley, A.R. Brown, R.N. Marks, K. Mackay, R.H. Friend, P.L Bums, A.B. Holmes, Nature **347**, 539 (1990)
34 D. Braun, A.J. Heeger, App. Phys. Lett **58** (18), 1982 (1991)
35 N.C. Greenham, S.C. Moratti, D.D.C. Bradley, R.H. Friend, A.B. Holmes, Nature **365**, 628 (1993)
36 G.G. Malliaras, J.K Herrema, J. Wildeman, R.H. Wieringa, R.E Gill, S.S.Lampoura, G. Hadziioannou, Adv. Mater. **5**, 721 (1993)
37 R.E. Gill, G.G. Malliaras, J. Wildeman, G. Hadziioannou, Adv. Mater **6**, 132 (1994)
38 D. Moses, App. Phys. Left **60** (26), 3215 (1992)
39 D. Moses, US patent 5237582 A, (1992)
40 A. Hilberer, J. Wildeman, B.J van der Scheer, G. Hadziioannou, submitted to Macromolecules
41 A. Tagaya et al., Appl. Phys. Lett **63**(7), 883-884 (1993)

## Claims

1. Light-emitting copolymer of the general structure:
-[Y-Z]-[Y'-Z]- _{y} (I)
wherein:
y ≧ 1;
Y and Y' are interruption unit(s) either the same or different and selected from the group consisting of 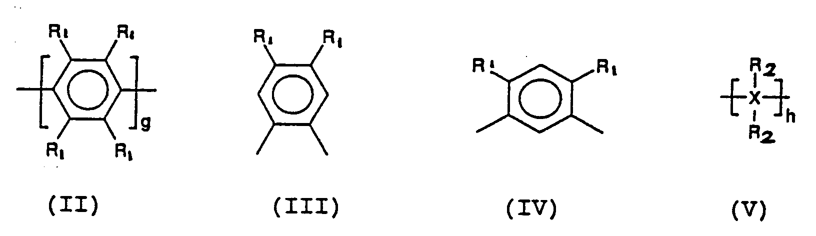
wherein X is C, Si, Ge, C-O, Si-O;
g ≧ 1 and R₁ may be the same or different within a Y or Y' unit and may or may not vary between successive Y or Y' units and is selected from the group consisting of hydrogen, aryl, nitro, crown-ether, (C₁-C₁₆)-alkyl, which alkyl may be either linear or branched and is linked to the phenyl ring either directly or by means of an intervening group selected from ether, ester, thioether, thioester, amino; and
h ≧ 1 and R₂ may be the same or different within a Y or Y' unit and may or may not vary between successive Y or Y' units and is hydrogen, (C₁-C₁₆)alkyl (linear or branched) or (C₁-C₁₆)alkoxy (linear or branched);
Z is a light-emitting unit of the general formula
-[A]ₐ-[B]_{b}- (VI)
wherein:
a ≧ 1;
A is a unit of the general formula: 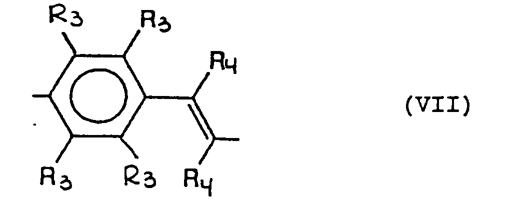
wherein R₃, may be the same or different within unit A and may or may not vary between successive units A and is selected from the group consisting of hydrogen, aryl, nitro, (C₁-C₁₆)alkyl, which alkyl may be either linear or branched and is linked to the phenyl ring either directly or by means of an intervening group selected from ether, ester, thioether, thioester, amino; and
wherein R₄ is the same or different within unit A and may or may not vary between successive units A and is selected from the group consisting of hydrogen, C≡N (nitrile), ester, aryl;
b is 0 or 1;
B is a group of the general formula: 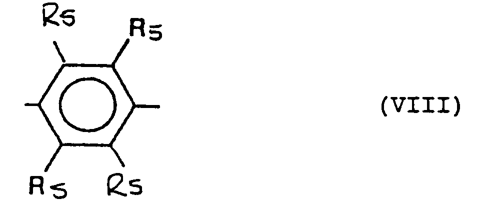
wherein R₅ may be the same or different within unit B and may or may not vary between successive units B and is selected from the group consisting of hydrogen, aryl, nitro, (C₁-C₁₆)alkyl, which alkyl may be either linear or branched and is linked to the phenyl ring either directly or by means of an intervening group selected from ether, ester, thioether, thioester, amino;
or B is a group of the general formula: 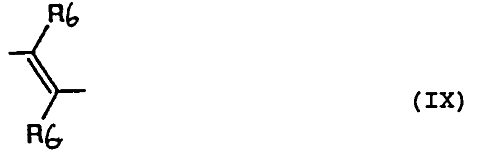
wherein R₆ is the same or different within unit B and may or may not vary between successive units B and is selected from the group consisting of hydrogen, C≡N (nitrile), ester, aryl.

2. Light-emitting copolymer as claimed in claim 1, **characterized** by the general structure: 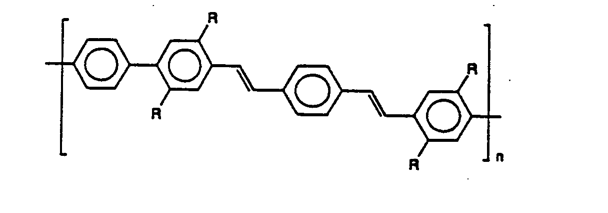 wherein n is preferably ≧ 2 and ≦ 200 and R is C₈H₁₇, O-C₈H₁₇ or O-C₄H₉.

3. Light-emitting copolymer as claimed in claim 1, **characterized** by the general structure: 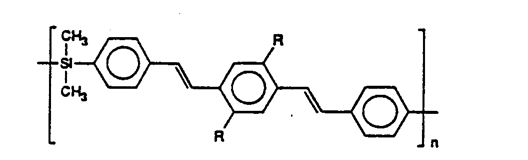 wherein n is preferably ≧ 2 and ≦ 200 and R is C₈H₁₇, O-C₈H₁₇ or O-C₄H₉.

4. Light-emitting copolymer as claimed in claim 1, **characterized** by the general structure: 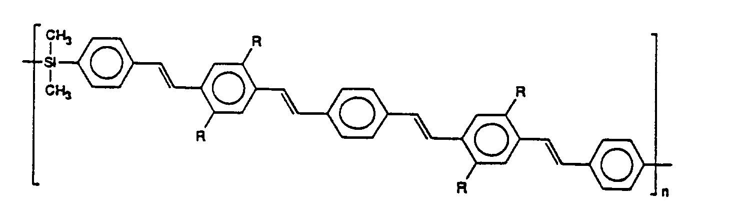 wherein n is preferably ≧ 2 and ≦ 200 and R is O-C₈H₁₇.

5. Light-emitting copolymer as claimed in claim 1, **characterized** by the general structure: 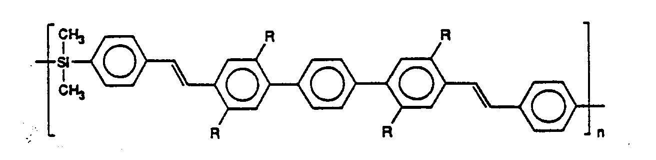 wherein n is preferably ≧ 2 and ≦ 200 and R is -C₄H₉, -O-C₈H₁₇ or O-C₄H₉.

6. Light-emitting copolymer as claimed in claim 1, **characterized** by the general structure: 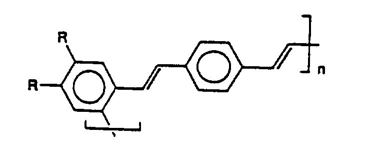 wherein n is preferably ≧ 2 and ≦ 200 and R is O-C₈H₁₇ or

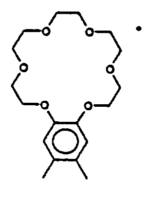

7. Light-emitting copolymer as claimed in claim 1, **characterized** by the general structure: 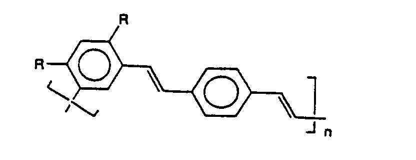 wherein n is preferably ≧ 2 and ≦ 200 and R is O-C₈H₁₇.

8. Dye laser, comprising:
a) a laser dye solution disposed in a resonant cavity comprising a copolymer as claimed in any one of the claims 1-7, and a non-aqueous solvent, the solvent being substantially unable to chemically react with the copolymer and to absorb and emit light at a wavelength similar to the copolymer, and
b) a pumping energy source creating population inversion in the dye solution.

9. Dye laser as claimed in claim 8, wherein the wavelength of the pumping energy source comprises about 300 to 600 nm.

10. Dye laser as claimed in claim 8 or 9, wherein the copolymer is one of the copolymers as claimed in claims 2-7 and wherein the wavelength of the stimulated emission comprises about 400-600 nm.

11. Dye laser as claimed in claim 8, 9 or 10, wherein the solvent is a liquid solvent selected from the group consisting of xylene, methanol, chloroform, toluene, tetrahydrofuran, chlorobenzene, dichlorobenzene and hexane.

12. Dye laser as claimed in any one of the claims 8-11, wherein the copolymer is present in the solution at a concentration of about 0.1 to 10 mg/ml.

13. Dye laser as claimed in claim 8, wherein the laser dye solution has been replaced by a copolymer dispersed in a solid polymer matrix.

14. Laser dye solution comprising a copolymer as claimed in any one of the claims 1-7, and a non-aqueous solvent, the solvent being substantially unable to chemically react with the copolymer and to absorb and emit light at a wavelength similar to the copolymer.

15. A method of producing a coherent laser emission in the operation of a dye laser in the wavelength range of about 400-600 nm comprising placing in an optically resonant cavity and optically pumping a laser dye solution as claimed in claim 13, comprising a copolymer as claimed in any one of the claims 2-7, to produce a population inversion in the laser dye solution with resulting stimulated emission.

16. Light-emitting device, comprising a film of a copolymer as claimed in any one of the claims 1-7 on a solid (rigid or flexible) support and two electrodes.

17. Polymer optical fiber amplifier, comprising as a dye the copolymer as claimed in any one of the claims 1-7.

18. Polymer optical fiber amplifier as claimed in claim 17, wherein the copolymer is dispersed in a polymer matrix forming a wave guide or fibre.

19. Solid state dye laser, comprising a pure copolymer as claimed in any one of the claims 1-7 or such a copolymer dispersed in an appropriate polymer matrix.

20. Microcavity LED, comprising the copolymer as claimed in any one of the claims 1-7 as such or in a suitable solid medium sandwiched between two flat reflecting electrodes (Fabry-Perot configuration) serving also for the injection of holes and electrons.
